# EUROPEAN PATENT APPLICATION

(11) **EP 2 110 844 A1**
(43) Date of publication of application: **21.10.2009**
(21) Application number: 08154575.8
(22) Date of filing: 15.04.2008
(51) Int. Cl.: H01J 37/244, G01R 19/00, H01J 37/24

(54) **Contactless measurement of beam current in charged partical beam system**

(71) Applicant: ICT, Integrated Circuit Testing Gesellschaft für Halbleiterprüftechnik Mbh, 85551 Heimstetten (DE)
(72) Inventor: Frosien, Jürgen, 85521 Riemerling (DE)
(74) Representative: Zimmermann & Partner

(57) **Abstract**

A beam current measurement assembly for measuring a current of a charged particle beam in a charged particle beam device having a charged particle beam source is described. The beam current measurement assembly includes a beam modulation unit for repeatedly changing the current of the charged particle beam for providing a modulated charged particle beam, and a measurement unit adapted for measuring an inductive signal generated by the repeatedly changing charged particle beam current.

## Description

### FIELD OF THE INVENTION

The invention generally relates to a charged particle beam device and a method of operating a charged particle beam device. In particular, it relates to a charged particle beam device having elements for primary beam current measurement and a method for primary beam current measurement. Specifically, it relates to a beam current measurement assembly, a charged particle beam device, and a method of measuring a beam current of a primary charged particle beam.

### BACKGROUND OF THE INVENTION

Charged particle beam apparatuses have many functions in a plurality of industrial fields, including, but not limited to, inspection of semiconductor devices during manufacturing, exposure systems for lithography, detecting devices and testing systems. Thus, there is a high demand for structuring and inspecting specimens within the micrometer and nanometer scale.

Micrometer and nanometer scale process control, inspection or structuring is often done with charged particle beams, e.g. electron beams, which are generated and focused in charged particle beam devices, such as electron microscopes or electron beam pattern generators. Charged particle beams offer superior spatial resolution compared to, e.g. photon beams, due to their short wavelengths.

Thereby, charged particle beam devices, in particular systems for accurate measurements like metrology systems, CD measurement systems in the chip industry, EDX in material analysis, inspection of wafers and masks, or the like, have a desire for a stable, defined beam current. Furthermore, quantitative measurements require a stable beam current. Standard systems often use a Faraday cup connected to an electrometer in order to measure the beam current on a regular basis. Thereby, during periodic maintenance, e.g. on a daily basis, the beam current is measured and readjusted to the required value. This process is time-consuming and unacceptable if the operation of the charged particle beam device should not be interrupted for a long time or if the beam current measurement should be conducted more frequently.

### SUMMARY OF THE INVENTION

In light of the above, a beam measurement assembly according to independent claim 1, a charged particle beam device according to claim 12, and a method of measuring the beam current of a primary beam of a charged particle beam device according to claim 16 are provided.

According to one embodiment, a beam current measurement assembly for measuring a current of a charged particle beam in a charged particle beam device having a charged particle beam source is provided. The beam current measurement assembly includes a beam modulation unit for repeatedly changing the current of the charged particle beam for providing a modulated charged particle beam, and a measurement unit adapted for measuring an inductive signal generated by the repeatedly changing charged particle beam current.

According to another embodiment, a charged particle beam device is provided. The charged particle beam device includes a charged particle beam source adapted for emitting a primary charged particle beam, a specimen location adapted for holding a specimen, a beam modulation unit for repeatedly changing the current of the charged particle beam for providing a modulated charged particle beam, and a measurement unit adapted for measuring an inductive signal generated by the repeatedly changing charged particle beam current.

According to yet another embodiment, a method of measuring the beam current of a charged particle beam of a charged particle beam device having a charged particle beam source is provided. The method includes modulating the charged particle beam current, and inductively measuring the charged particle beam current for generating a measured signal.

Further advantages, features, aspects and details that can be combined with the above embodiments are evident from the dependent claims, the description and the drawings.

Embodiments are also directed to apparatuses for carrying out the disclosed methods and including apparatus parts for performing each described method step. These method steps may be performed by way of hardware components, a computer programmed by appropriate software, by any combination of the two or in any other manner. Furthermore, embodiments are also directed to methods by which the described apparatus operates. It includes method steps for carrying out every function of the apparatus or manufacturing every part of the apparatus.

### BRIEF DESCRIPTION OF THE DRAWINGS

Some of the above indicated and other more detailed aspects of the invention will be described in the following description and partially illustrated with reference to the figures. Therein:

Figure 1 shows a schematic view of a charged particle beam device including measuring a beam current with a Faraday cup;

Figure 2 shows a schematic view of a charged particle beam device for improved beam current measurement according to the embodiments described herein;

Figure 3 shows a schematic view of a further charged particle beam device for improved beam current measurement according to the embodiments described herein;

Figures 4A to 4C show diagrams of a chopped beam current usable for a charged particle beam current measurement according to embodiments described herein;

Figures 5a and 5B show a schematic view of beam current modulation components that can be used for charged particle beam devices and methods of operating charged particle beam devices according to embodiments described herein;

Figure 6 shows a schematic view of yet further charged particle beam devices for improved beam current measurement according to the embodiments described herein;

Figures 7A and 7B show schematic views of an even further charged particle beam device for improved beam current measurement according to the embodiments described herein; and

Fig. 8 illustrates different operation methods according to embodiments described herein.

### DETAILED DESCRIPTION OF THE DRAWINGS

Without limiting the scope of the present application, the charged particle beam device or components thereof will, in the following, exemplarily be referred to as an electron beam device or components thereof. Thereby, the electron beam might especially be utilized for inspection or lithography. The present invention can still be applied for apparatuses and components using other sources of charged particles and/or other secondary and/or backscattered charged particles to obtain a specimen image or to pattern a specimen.

Within the following description of the drawings, the same reference numbers refer to the same components. Generally, only the differences with respect to the individual embodiments are described.

Without limiting the scope of protection of the present application, in the following the charged particle beam device or components thereof will exemplarily be referred to as a charged particle beam device including the detection of secondary electrons. The present invention can still be applied for apparatuses and components detecting corpuscles such as secondary and/or backscattered charged particles in the form of electrons or ions, photons, X-rays or other signals in order to obtain a specimen image.

Generally, when referring to corpuscles it is to be understood as a light signal, in which the corpuscles are photons, as well as particles, in which the corpuscles are ions, atoms, electrons or other particles.

A "specimen" as referred to herein, includes, but is not limited to, semiconductor wafers, semiconductor workpieces, and other workpieces such as memory disks and the like. Embodiments of the invention may be applied to any workpiece on which material is deposited, which is inspected or which is structured. A specimen includes a surface to be structured or on which layers are deposited, an edge, and typically a bevel.

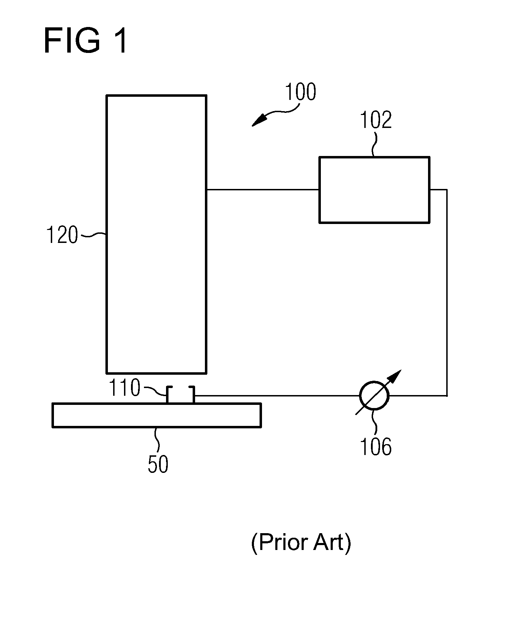

Figure 1 illustrates a charged particle beam device 100. The charged particle beam device 100 includes a charged particle beam column 120. The control unit 102 is connected to the charged particle beam column 120. For example, the control unit 102 controls beam guiding units, deflectors, lenses, detectors, or the like.

The charged particle beam device 100 further includes a specimen support 4. Figure 1 shows a Faraday cup 110 and electrometer 106, which are connected to the control 102. The Faraday cup 110 and the electrometer 106 may be connected to another control unit.

During an imaging mode of the charged particle beam device 100 a specimen can be placed on the specimen support 4. The primary charged particle beam is guided onto a specimen and secondary and/or backscattered particles are detected by a detection unit. A beam current measurement of the primary charged particle beam can be used to compensate for primary beam current fluctuations.

In order to control the beam current, a Faraday cup 110 connected to an electrometer 106 can be positioned in the charged particle beam device 100 to measure the primary beam current with the Faraday cup and the electrometer. The beam current values measured thereby are fed to the control 102 or another control unit. Thereby, a verification and/or adjustment of the beam current can be conducted.

Generally, the charged particle beam is deflected magnetically electrically or combined electrically-magnetically to an isolated electrode, typically a Faraday cup. The current from this measurement electrode can be fed to a current amplifier. Thereby, the electrode can be a Faraday cup as shown in figure 1, a biased Faraday cup, which may additionally trap secondary particles, or another metal part that might be biased to suppress backscattered and secondary particles escape.

As shown in figure 1, the Faraday cup or the like can be arranged on the sample stage. Alternatively, the Faraday cup or another electrode can be positioned inside the particle beam column.

However, a measurement on the sample stage generally requires that the Faraday cup or the measurement electrode is placed in the beam. This can require a time-consuming stage movement, which might not be tolerable in a plurality of systems such as high throughput inspection, metrology and other applications, in particular for semiconductor industry, wherein the measurement tool is integrated in the production process.

A probe current measurement with a Faraday cup or another measurement electrode inside the column can be difficult in systems for which the beam is provided at a beam boost potential. Beam boost potential means that the inside of the column is not at ground potential. In particular for high performance low energy columns, the beam is accelerated to a high energy of several keV within the column. In such configurations the probe current measurement would also need to be performed at the high potential, which yields problems regarding the measurement result.

In light of the above, an improved probe current measurement in charged particle beam devices can be provided according to embodiments described herein. Thereby, the term "probe current" refers to the charged particle beam current on a specimen. This can be understood as having a charged particle beam as a probe on a specimen, e.g. for scanning electron microscopes. Accordingly, for some embodiments, which can be combined with other embodiments described herein, a charged particle beam current measurement can typically be performed after blocking a portion of a charged particle beam by electron optical elements. If for example a beam shaping aperture is provided in the system, which blocks a portion of the charged particle beam to thereby shape the charged particle beam, a beam current measurement device can for example be positioned after the last beam shaping aperture. Thereby, the beam current measured with the measurement device equals essentially the beam current that would impinge on the specimen, i.e. the probe current.

According to other embodiments, which might be combined with any of the embodiments described herein, an improved beam current measurement device might also be provided above a beam shaping aperture or another element blocking a portion of the charged particle beam. In this case the calibration based on the beam diameter before and behind the beam blocking elements, e.g. a beam limiting aperture, can be conducted to determine the final probe current based on the measured beam current. Thereby, higher beam currents are to be measured, which might simplify the measurement device, in particular if low beam currents are provided in the system.

According to different embodiments described herein, a charged particle beam current measurement or a probe current measurement can be in particular useful for scanning electron microscopes, focused ion beam systems, and lithography tools based on electrons or ions. The methods and apparatuses described herein might typically be used for metrology applications, critical dimension measurements, and inspection of wafers and masks. A lithography tool might also be a typical application. According to yet further embodiments, which can be combined with any of the documents described herein, a method for measuring a charged particle beam current or a probe current, charged particle beam measurement assemblies or probe current measurement assemblies can be used to control the charged particle beam current. Accordingly, the current can be measured and controlled in response to the measurement result to deliver the desired current on the specimen.

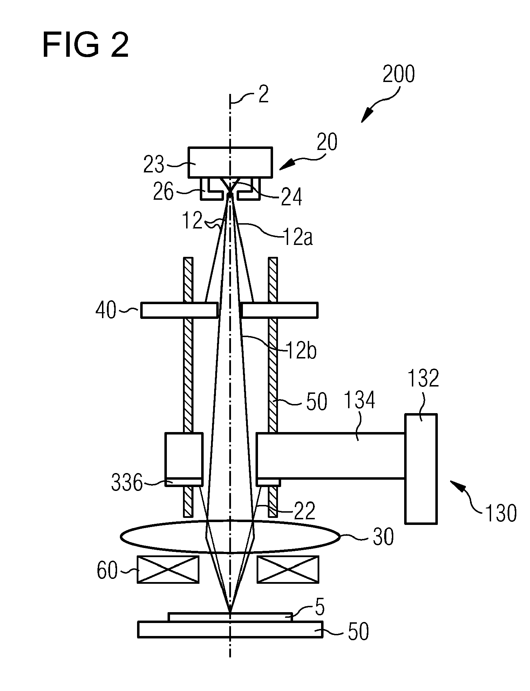

Fig. 2 illustrates a principle set-up for explaining embodiments according to the invention. Therein, a charged particle beam device 200 is provided. A charged particle beam 12 is emitted by a charged particle gun 20. The gun 20 includes an emitter 24 attached to a base 23 and a suppressor 26. The charged particle beam is essentially emitted along the optical axis 2. A beam shaping aperture 40 can be provided in the charged particle beam device. As shown in Fig. 2, the aperture 40 is a beam shaping aperture or beam limiting aperture that blocks a portion of the charged particle beam and shapes the beam. Accordingly, the beam current of the charged particle beam 12a before the beam shaping aperture 40 is higher than the beam current of the charged particle beam 12b after the beam shaping aperture. However, as will be apparent to a person skilled in the art, charged particle beam generation, shaping, correction and guiding of the charged particle beam towards the specimen 5 during imaging of the specimen can be conducted in many ways, which are known to a person skilled in the art. Corresponding elements, which might be incorporated in embodiments described herein, can include one or more elements of the group of: a condenser lens, an anode, an alignment deflector, a scanning deflector, a stigmator, or the like.

As shown in Fig. 2, the primary charged particle beam 12 passes through an opening in the detection unit 130 and is focused on the specimen 5 on the specimen support 4 by objective lens 30. The secondary and/or backscattered particles 22 released thereby from the specimen trespass back through the objective lens 30. The secondary and/or backscattered particles impinge on the scintillation element 336. The signal generation of the detection unit 130 includes photon generation in a scintillation element, guiding of the photons in a light guide 134 and signal generation in the PM 132.

Generally, it is possible according to some embodiments that the primary charged particle beam 12 is decelerated by an appropriate potential of the specimen and the secondary and/or backscattered charged particles are accelerated away from the specimen 5 towards the detection unit.

According to some embodiments, which can be combined with other embodiments described herein, as illustrated in Fig. 2, the charged particle beam 12/12b is scanned over the specimen 5 with scanning deflector 60. Thereby, the specimen can be scanned, e.g. raster scanned or vector scanned for image generation.

As shown in figure 2, an electrode 50 or electrode tube 50 can be provided at a high potential, i.e., a beam boost potential, to accelerate the charged particle beam when traveling through the column of the charged particle beam device 200. By increasing the energy of the charged particles within the column by at least a factor of 2, 5, 10 or even more, electron-electron-interactions can be reduced in light of the shorter flight time in the system. As can be understood from the schematic view shown in figure 2, a charged particle beam current measurement within the beam boost tube 50 might yield further difficulties.

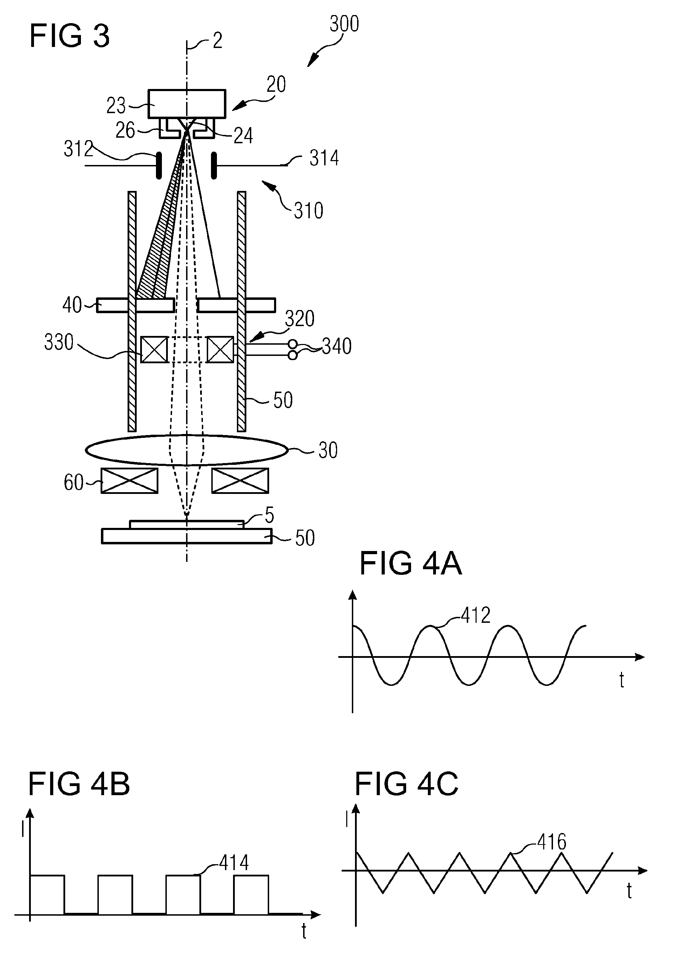

Accordingly, the measurement system as for example shown in figure 3 can be provided according to embodiments described herein.

The charged particle beam device 300 shown in figure 3 includes similar components as the charged particle beam device shown in figure 2. However, additionally a beam modulation unit 310 and a measurement unit 320 are provided. The measurement unit measures the charged particle beam current inductively due to the modulation of the charged particle beam. Accordingly, a beam current measurement at ground potential can be conducted even for increased, i.e., high charged particle beam energies in the column. Further, the stage movement of a Faraday cup on the stage 4 can be avoided.

As shown in figure 3, the charged particle beam device 300 include a source 20, at least one lens such as an objective lens 30, and a specimen 5 located on a specimen stage 4 providing a specimen location for the device. According to some embodiments, it is possible that a scanning system 60 is included in the system. Typically, for electron beam devices, the source can be imaged on the specimen 5 in a demagnifying manner. However, these applications and other applications, such as for example gas field ion source applications, might require less or no demagnification of the source. If for example a scanning electron microscope is considered as a charged particle beam device 300, the probe, i.e. the charged particle beam 12, is scanned over the sample using the scanning system 60 to image, modify or expose the specimen. According to some embodiments, if the specimen is to be imaged, additionally a detector for secondary and/or backscattered particles can be provided. According to yet further embodiments, charged particle beam devices include further elements that can be provided in the column. Corresponding elements, which might be incorporated in embodiments described herein, can include one or more elements of the group of: a condenser lens, an anode, an alignment deflector, a scanning deflector, a stigmator, or the like.

According to some embodiments, as shown in figure 3, the beam shaping aperture 40, i.e. beam limiting aperture, is provided in the column and finally defines the charged particle beam current on the specimen 5, i.e. the probe current.

According to different embodiments, which can be combined with other embodiments described herein, the probe current can be adjusted by varying the source brightness, by using differently sized beam shaping apertures 40, and/or by using a condenser lens system for changing the divergent angle provided at a beam blocking element such as a beam shaping aperture.

The measurement unit 320 is a contactless measurement device, which typically measures the charged particle beam current inductively. Thereby, a voltage can be induced by repeatedly changing the current of the charged particle beam, e.g. by modulating or pulsing the charged particle beam current.

According to some embodiments, which can be combined with other embodiments described herein, the measuring unit is provided by a conductive loop 330 in the vicinity or typically around the charged particle beam. The conductive loop is connected to electrical connections 340 at which the induced voltage can be measured. Basically this arrangement might be interpreted as a transformer in which the modulated charged particle beam is the primary coil (having one winding) and having a secondary coil 330 around the charged particle beam. According to alternative implementations, a magnetic ring can be located around the modulated beam. The magnetic ring can carry a coil which is wound on this ring. Thus, the secondary coil is provided around the magnetic circuit.

Accordingly, a secondary coil similar to a transformer can be provided, e.g., around the charged particle beam to be measured (see, e.g., Fig. 3) or a magnetic circuit can be provided, e.g., around the charged particle beam and a coil can be provided on the magnetic circuit. The magnetic coil is connected to electrical connections 340 at which the induced voltage can be measured.

In light of the above, if for example a charged particle beam current is modulated to be sine-shaped, the induced voltage U₀ can be calculated for typical parameters to be between about 400 and 1600 times I₀. If for example the induced voltage equals 800 times the beam current I_{0,} a voltage of 800 nV/nA is measured.

According to typical embodiments, which can be combined with other embodiments described herein, a relative permeability of the magnetic ring or circuit can be in a range of 500 to 5000, typically, 1000. According to other alternatives, magnetically soft materials (e.g., mu metal or the like) with a relative permeability of up to 40000, typically in a range of 10000 to 35000 can be used, in particular if eddy currents are suppressed by appropriate countermeasures.

According to different embodiments, eddy currents might be suppressed by laminating layers of the material with isolators in between. Thereby, the lamination can be provided by tube-shaped layers forming a cylinder through which the charged particle beam can trespass. Alternatively, a lamination of flat layers with isolation in between can be provided, wherein the stack of layers provide a magnetic circuit or ring.

According to yet other typical embodiments, which can be combined with other embodiments described herein, the number of windings of the secondary coil can be in a range of 50 to 200, typically 100, the height of the magnetic circuit can be in a range of 5 mm to 20 mm, typically 10 mm, the width of the magnetic circuit can be in range of 2 mm to 10 mm, typically 5 mm, the radius if the magnetic circuit can be in the range of 3 mm to 12 mm, typically 5 mm, and/or ω of ω = 2·π·f (f being the blanking frequency) can be in a range of 6·10⁶ Hz.

According to some embodiments, which can be combined with other embodiments described herein, the beam modulation unit or chopper can be a capacitive beam blanker. A capacitive beam blanker may deflect the beam according to the applied blanker voltages. As shown in figure 3, the beam modulation unit including electrode 312 and connections 314 for applying a beam blanking voltage, deflects the charged particle beam 12. The charged particle beam moves over the opening in the beam shaping aperture 40. If the deflection amplitude is larger than the beam bundle opening angle, which may for example be pre-defined by a previous aperture, the beam can be switched on or off behind the beam shaping aperture 40.

By applying a capacitive beam blanker, which deflects the beam, a high-frequency modulated probe current can be generated, wherein the charged particle beam current behind the beam shaping aperture 40 is repeatedly changed. For example a modulation with ω = 2·π·f (f being the blanking frequency) can be generated. As shown in figures 4A to 4C, according to different embodiments, the beam current behind the beam blanking aperture can be modulated such that a pulsed beam current is generated. According to different examples the beam current can have a sine shape (see figure 4A), a rectangular shape (see figure 4B), or a triangular shape (see figure 4C.) According to yet other embodiments, other geometries depending on the blanker signal and the beam opening angle can be generated.

As for example described above, according to embodiments described herein, a measurement of the charged particle beam current or the probe current can be conducted by using a beam chopping system and a contactless measurement device, which might typically be an inductive device.

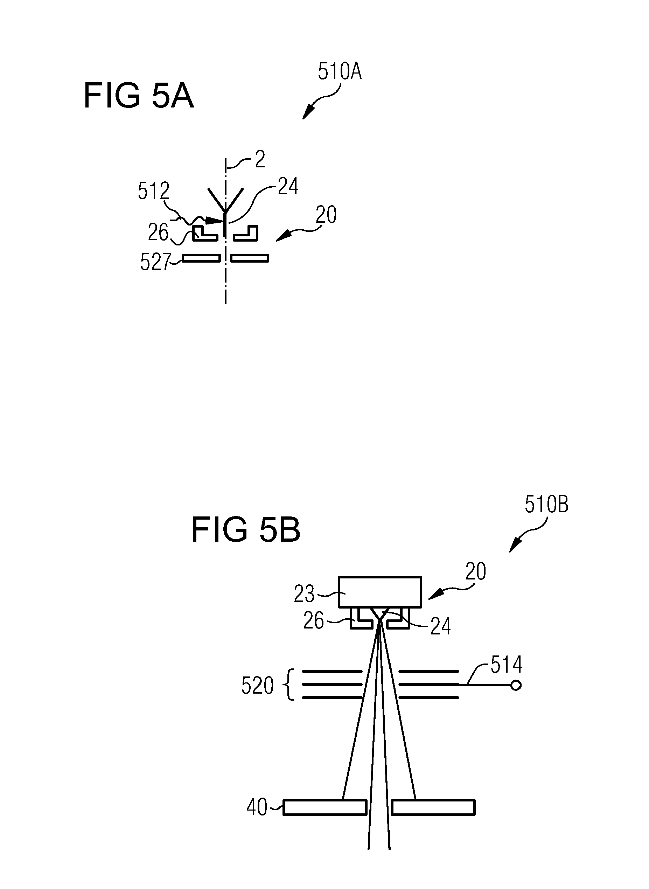

As shown in figures 5A and 5B, additional or alternative beam modulation units can be used. Figure 5A shows a beam modulation unit 510A. Thereby, a charged particle beam source 24, a suppressor 26 and an acceleration electrode 527 are provided. The charged particle beam source emits a charged particle beam essentially along the optical axis 2. According to embodiments described herein, it is possible that a modulation or pulsing of the source can be used. Reference 512 in figure 5A denotes a laser beam. According to one example, if a pulsed laser beam is provided on a photocathode the emitted charged particle beam can be pulsed or modulated in a desired manner. Accordingly, according to some embodiments described herein, a modulation or pulsing of the source may alternatively or additionally be provided.

Figure 5B illustrates another option for a beam modulation unit 510B. A charged particle beam is emitted by a charged particle beam source 20 having an emitter 24, which is mounted to a base 23, and suppressor 26. Reference 520 denotes an electrostatic deceleration lens. For example, the center electrode of the lens 520 can be at a potential which decelerates the charged particles trespassing through the opening in the lens 520. As shown in figure 5B, for example the center electrode can be provided with an electrical connection 514 for providing a modulated voltage to the center electrode. Thereby, an electrostatic mirror lens can be provided which might reflect the electron beam backwards depending on the applied voltage. Accordingly, depending on the voltage applied to the center electrode (or another electrode of the deceleration lens 520) the charged particles trespassing the opening in the lens can be controlled. Thereby, the beam can be switched on or off. Thus, a modulation or pulsing of the charged particle beam can be provided.

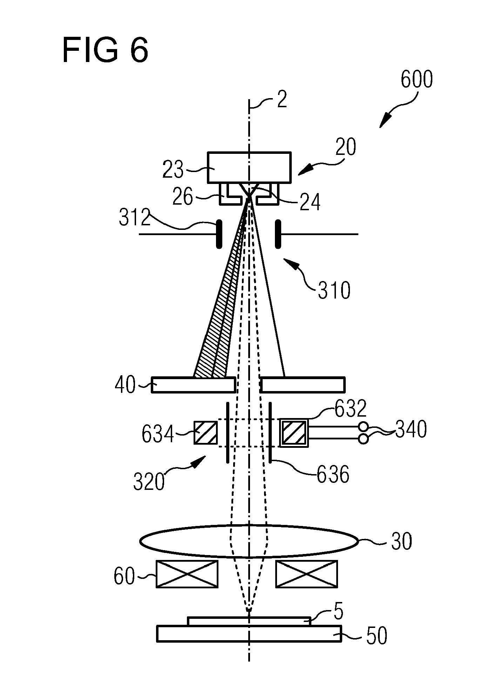

According to further embodiments, as illustrated in figure 6, a charged particle beam device 600 can be provided. The charged particle beam device 600 includes a beam modulation unit, which can for example be at a capacitive beam blanker having an electrode 312 and an electrical connection. The capacitive beam blanker deflects the charged particle beam 12 with respect to an opening in the beam shaping aperture 40 or another aperture. Accordingly, the beam can be modulated or pulsed. The measurement unit 320 includes a coil 632 which is provided around a magnetic ring 634. The induced voltage from the modulated charged particle beam current can be measured at the electrical connections 340. According to some embodiments, which can be combined with other embodiments described herein, a tube 636 such as an alignment tube can be provided within the measurement unit 320. The alignment tube separates the transformer including the magnetic ring 634 and the coil 632 from the charged particle beam. According to different implementations, which might alternatively or additionally be provided, an alignment tube might be provided for vacuum isolation and/or for supplying a beam liner voltage. According to typical implementations, the tube can be made from a thin and/or high resistance material in order to reduce or avoid eddy currents. Further, typically non-magnetic materials can be used.

In light of the above, according to further embodiments, a method of measuring the beam current of a charged particle beam can be provided. The method includes modulating or pulsing the charged particle beam and inductively measuring the charged particle beam current for generating a measurement signal. Thereby according to typical implementations, a high-frequency beam modulation, for example, provided by a chopper system, having a modulation frequency of 100 Hz or higher can be provided. For example, the modulation frequency can be in a range of 100 Hz to 5 MHz or even up to 8 MHz. By increasing the frequency, the induced voltage can be increased, which might simplify the measurement of the induced voltage, in particular if low beam currents have to be measured.

According to yet further embodiments, which can be combined with other embodiments described herein, the beam current measurement assembly can include a ferrite iron circuit as a magnetic ring. Alternatively other materials like mu-metal or other magnetically soft materials as well as materials used for high frequency. A high-frequency transformation with low eddy currents can be provided by the choice of material. According to other alternative or additional implementations, a lamella arrangement or tube-shaped laminated layers might be possible for the magnetic ring.

As mentioned above, for embodiments having a liner tube for separating the measuring unit acting as a transformer from the charged particle beam, the liner tube can be provided from a thin material and/or from a high resistance material in order to reduce or avoid eddy currents. Typically, the material is nonmagnetic.

According to yet further embodiments, which can be combined with other embodiments described herein, the transformer, i.e. the measurement unit, should closely surround the charged particle beam. Thereby a higher signal can be generated.

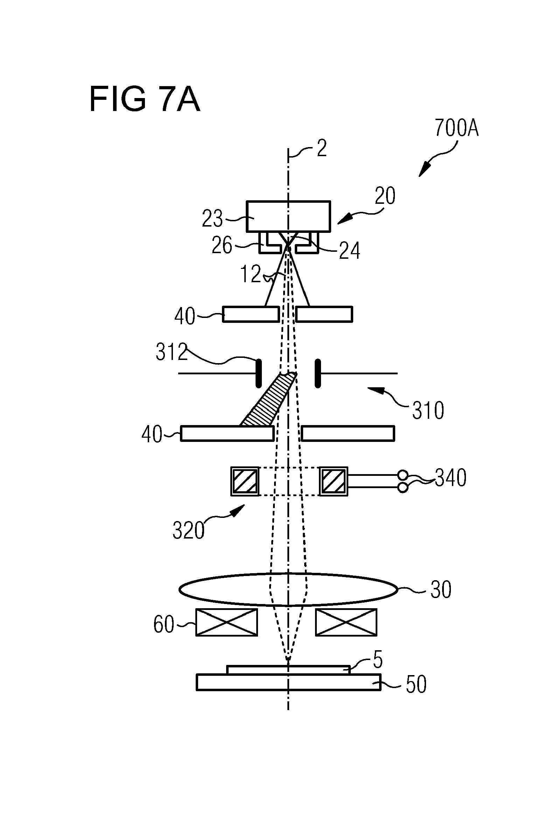

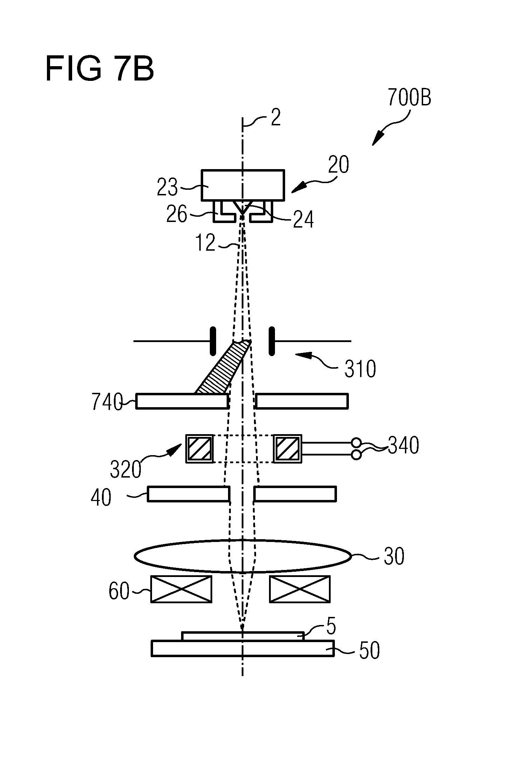

The above described figures refer to embodiments having the modulation unit above a beam shaping aperture 40 and an inductive measurement unit below a beam shaping aperture unit. That is, a beam blocking means is provided between the modulation unit and the beam measurement unit. Figures 7A and 7B illustrate further embodiments, which might be combined with other embodiments described herein. Figure 7A shows a charged particle beam device 700A wherein a charged particle beam 12 is emitted by a charged particle beam source 20. A beam limiting aperture 40 blocks a portion of the charged particle beam. The beam modulation unit 310, e.g., in form of a capacity beam blanker, is provided below (after) the beam shaping aperture 40 and deflects the beam with respect to an opening in the aperture 640. That is, the beam modulation unit and the measurement unit are provided between a beam blocking element and a specimen location. As soon as the blanker deflection amplitude is larger than a beam bundle opening angle of the charged particle beam, the beam is switched on and off behind the aperture 640. Thereby the modulation of the charged particle beam is generated which can be measured by the measuring unit 320.

According to yet further embodiments, as shown in figure 7B, the beam modulation unit 310 modulating the beam by deflecting the beam with respect to an opening in the aperture 740 is provided above a beam shaping aperture 40 or a beam limiting aperture. Further, the inductive measuring unit 320 is provided above the beam limiting aperture 40. That is, the beam modulation unit and the measurement unit are provided between a beam blocking element and the charged particle beam source. According to this and corresponding embodiments, the charged particle beam current measured by the measurement unit 320 is changed by the beam shaping aperture 40. Accordingly, the charged particle beam current on a specimen 5 is generally not equal to the measured charged particle beam current. However, in light of the fact that less or no charged particle beams are blocked before the position at which the charged particle beam measurement is conducted, a higher voltage signal is generated by the inductive measurement system.

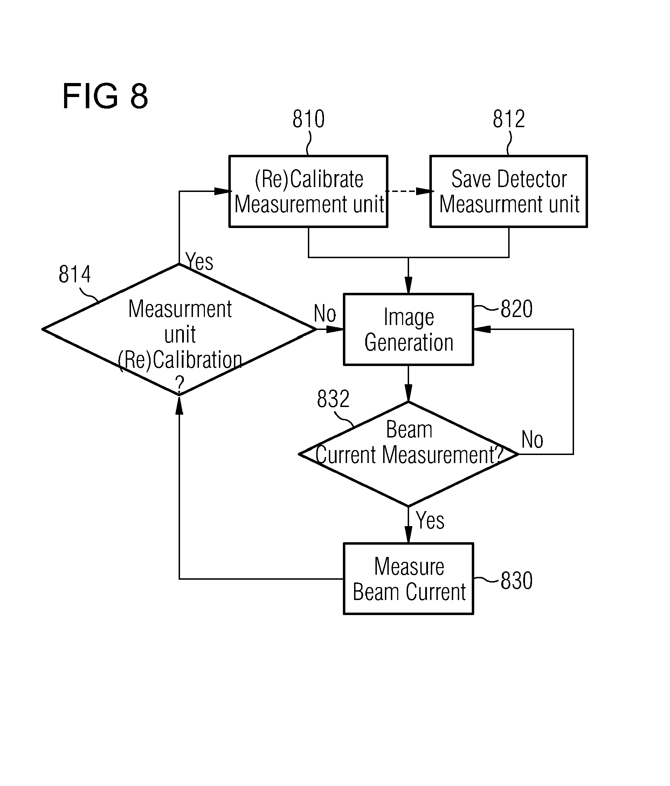

Accordingly, a calibration or conversion from the measured beam current to the probe current might be desired. Therefore, the calibration can, according to some embodiments, be conducted with measuring the probe current, i.e. the charged particle beam current, at the specimen position with a Faraday cup as shown in figure 1. The corresponding method of operating a charged particle beam device is shown in figure 8.

Accordingly, embodiments can include the calibration of the measurement unit 130 on a regular basis. According to some embodiments, the signal obtained from the measurement unit 320 is compared to a signal obtained by a Faraday cup (electrometer). Thereby, the measurement unit signal can be calibrated to the value measured by the electrometer. Typically, different beam currents are generated during calibration, such that a calibration curve (e.g. linear) for the primary beam current as a function of the measurement unit signal can be realized.

For example, the calibration can be conducted every 24 hours, during regular maintenance periods, or at other time intervals in order to avoid a drift of the beam current measurement.

The control unit can be connectable to an electrometer measuring the primary beam current with a Faraday cup. Alternatively, if a calibration of the beam current measurement is conducted repeatedly, the control unit can be connected to a Faraday cup-electrometer-arrangement, which is provided in the charged particle beam device for regular calibration or re-calibration.

The measured beam current may be used to compensate for a fluctuation or jump in the primary charged particle beam current. For example, a jump or variation of the beam current might be introduced during a flashing process of a cold field emitter (CFE). Compensation might be conducted using the extractor voltage, the suppressor voltage or other methods.

According to different embodiments, an adjustment of a charged particle beam current can be conducted according to one or more of the following procedures. For example in the case of a TFE cathode, the suppressor voltage can be adjusted to change the charged particle beam current in the column and/or on the specimen. Additionally or alternatively, an extractor voltage can be adjusted accordingly. For example in the case of a CFE cathode, the suppressor voltage can be adjusted to change the charged particle beam current in the column and/or on the specimen. Additionally or alternatively, especially in the event a suppressor is not provided, an extractor voltage can be adjusted accordingly. For example in the case of a photo cathode, the light beam for controlling the photo cathode might be adjusted for changing the charged particle beam current in the column and/or on the specimen. For example in the case of a gas field ion source, the suppressor voltage can be adjusted to change the charged particle beam current in the column and/or on the specimen. Additionally or alternatively, especially in the event a suppressor is not provided in the column, an extractor voltage can be adjusted accordingly. According to a further option that might additionally, or alternatively be provided, the focusing strength of a condenser lens, which changes the divergence angle in front of a beam limiting element such as a beam limiting or beam shaping aperture, might be adjusted to change the charged particle beam current in the column and/or on the specimen

During operation, adsorption and desorption of residual gas molecules might occur on the emitting surface of e.g. cold field electron emitters. These adsorptions and desorptions lead to continuously degraded and momentarily instable emission current respectively, so that the emitting surface has to be cleaned in regular intervals. Conventionally, this is done by a so-called "flashing" method. According to the flashing method, a heating current is supplied to the emitter so that the emitting surface heats up and the debris is removed from the surface

According to further embodiments a "flashing" or cleaning of the emitter might include any of the following. A resulting change in primary beam current can be compensated for as described above by the primary beam current measurement and the desired countermeasures. For example, photons can desorb gas molecules from metal surfaces, particularly in a vacuum. Therefore, the emitting surface of the emitter tip may be kept continuously clean by illuminating it with light. The photon source can, for example, be a laser. According to another embodiment of the present invention, the light source is a source of UV light, e.g. a UV laser. UV light has a higher energy and will directly excite the adsorbed atoms and/or molecules. Thus, UV light induces strong gas desorption while not heating the emitting surface. According to an even further embodiment, the light source is adapted for pulsed illumination of the emitting surface. Thus, in cases where the emission of photo electrons is very high or if the emitted photo electrons have an energy similar to the energy of the field-emitted electrons or if the light source emits high optical power, excess production of photo electrons, particularly within an energy range similar to the field-emitted electrons, or excess heating of the emitter can be prevented due to the pulsed operation of the light source.

Corresponding embodiments of methods are shown in figure 8. In step 810 the calibration for the detector is generated or provided to a charged particle beam device. According to some embodiments, the calibration of the beam current measurement assembly can be generated by a comparison to a measurement with the Faraday cup as described above. According to other embodiments, the calibration may be generated externally and fed into a memory of the charged particle beam device. As indicated by the dashed arrow, a step of saving the beam current measurement assembly calibration can optionally be included (812). According to yet other embodiments, a detector calibration can be directly saved in a memory of the charged particle beam device without any previous generation of calibration data within the present charged particle beam device. Within step 820 the charged particle beam device is used for image generation, whereby secondary and/or backscattered particles are detected by the detection unit. As long as the beam current of the primary charged particle beam does not require any adjustment (step 832: no), image generation can be continued. If within step 832 it is decided that the beam current control is required (step 832: yes) the method proceeds to step 830, whereby the primary charged particle beam current is controlled by a beam current measurement assembly according to embodiments described herein. According to some embodiments described herein, after step 830 it is decided whether or not a recalibration of the beam current measurement assembly is required. According to other embodiments, the method proceeds after step 832 to step 820. In any case, if no recalibration of the beam current measurement assembly is required; the charged particle beam device can further be operated by image generation (step 820). If in step 814 it is decided that a recalibration (or calibration) of the beam current measurement assembly is required, the method proceeds to step 810. Within step 810 new calibration data for correlating the primary charged particle beam current with the signal of the beam current measurement assembly is generated.

According to embodiments described herein, a beam current measurement assembly for measuring a current of a charged particle beam in a charged particle beam device having a charged particle beam source, can be provided. The beam current measurement assembly includes a beam modulation unit for repeatedly changing the current of the charged particle beam for providing a modulated charged particle beam, and a measurement unit adapted for measuring an inductive signal generated by the repeatedly changing charged particle beam current.

According to optional modifications, the beam modulation unit can be a chopper, the beam modulation unit can include one or more elements from the group consisting of: a capacitive beam blanker, a pulsing element for modulating the charged particle beam current from the charged particle beam source, an electrostatic deceleration lens with a modulated potential at an electrode thereof, the measuring unit can include a magnetic ring carrying a coil, for example, a magnetic ring being located around the modulated charged particle beam, the measuring unit is adapted for measuring the current of the charged particle beam without impingement of the charged particle beam on the measuring unit, and/or the measuring unit can be provided with at least 20 coil windings. According to typical implementations, which may additionally or alternatively be provided, the magnetic ring can be a ferrite iron circuit, a mu-metal or other materials known from high-frequency transformers, and/or the beam current measurement assembly may further include a tube within the measurement unit for separating the components of the measurement unit from the charged particle beam, the measurement unit can be provided with a distance of 2 mm or less from the charged particle beam and/or a voltage amplifier connected to the coil of the measurement unit, in particular a low path amplifier, or a voltage amplifier and a frequency filter.

According to yet further embodiments, a charged particle beam can be provided. The charged particle beam device includes a charged particle beam source adapted for emitting a primary charged particle beam, a specimen location adapted for holding a specimen, and a beam current measurement assembly according to any of the embodiments described herein.

According to additional or alternative implementations, the charged particle beam device can further include a beam shaping aperture for blocking a portion of the charged particle beam, for example such that the measurement unit is positioned between the beam shaping aperture and the specimen location and/or such that the beam modulation unit is positioned between the charged particle beam source and the beam shaping aperture.

According to yet further embodiments, methods of measuring the beam current of a charged particle beam of a charged particle beam device having a charged particle beam source can be provided. The methods include modulating the charged particle beam current, and inductively measuring the charged particle beam current for generating a measured signal. According to some additional or alternative modifications, which can be combined with other embodiments described herein, the charged particle beam current can be modulated with a chopper and wherein the modulation frequency is equal to or larger than 100 Hz, in particular between 100 Hz and 7 MHz, the modulating can be conducted with a beam blanker which deflects the beam over an aperture, in particular a beam shaping aperture, and/or the modulating can be conducted with a waveform selected from the group of: sine shaped, rectangular, and triangular. According to yet even further embodiments, which can be combined with other embodiments described herein, the measuring can include frequency filtering the measured signal for reducing the bandwidth of the measured signal and/or calibrating the measured signal with an electrometer measurement. For example, the measuring of the measured signal can be conducted at least every 10 min or at least every hour and the electrometer measurement can be conducted at time intervals of 24 hours or larger.

According to yet further embodiments, a method of controlling the beam current of a charged particle beam of a charged particle beam device , the method includes a method of measuring the beam current of a charged particle beam according to any of the embodiments described herein including modulating the charged particle beam current, and inductively measuring the charged particle beam current for generating a measured signal; and adjusting the charged particle beam current. Thereby, according to optional implementations, the adjusting is selected by a step selected from the group of: adjusting a voltage supplied at a suppressor, adjusting a voltage supplied at a extractor, adjusting a light intensity provided at a photo cathode, and adjusting a condenser lens focusing strength.

While the foregoing is directed to embodiments of the invention, other and further embodiments of the invention may be devised without departing from the basic scope thereof, and the scope thereof is determined by the claims that follow.

## Claims

1. A beam current measurement assembly for measuring a current of a charged particle beam in a charged particle beam device having a charged particle beam source, comprising:
a beam modulation unit for repeatedly changing the current of the charged particle beam for providing a modulated charged particle beam; and
a measurement unit adapted for measuring an inductive signal generated by the repeatedly changing charged particle beam current.

2. The beam current measurement assembly according to claim 1, wherein the beam modulation unit comprises at least one element from the group consisting of: a capacitive beam blanker, a pulsing element for modulating the charged particle beam current from the charged particle beam source, an electrostatic deceleration lens with a modulated potential at an electrode thereof.

3. The beam current measurement assembly according to any of claims 1 to 2, wherein the measuring unit comprises a magnetic ring carrying a coil.

4. The beam current measurement assembly according to claim 3, wherein the magnetic ring is located around the modulated charged particle beam.

5. The beam current measurement assembly according to any of claims 1 to 4, wherein the measuring unit is adapted for measuring the current of the charged particle beam without impingement of the charged particle beam on the measuring unit.

6. The beam current measurement assembly according to any of claims 1 to 5, wherein the measuring unit is provided with at least 20 coil windings.

7. The beam current measurement assembly according to any of claims 1 to 6, further comprising:
a tube within the measurement unit for separating the components of the measurement unit from the charged particle beam.

8. A charged particle beam device, comprising:
a charged particle beam source adapted for emitting a primary charged particle beam;
a specimen location adapted for holding a specimen; and
a beam current measurement assembly according to any of claims 1 to 10.

9. The charged particle beam device according to claim 8, further comprising:
a beam shaping aperture for blocking a portion of the charged particle beam, wherein the beam modulation unit is positioned between the charged particle beam source and the beam shaping aperture and wherein the measurement unit is positioned between the beam shaping aperture and the specimen location or between the beam shaping aperture and charged particle beam source.

10. A method of measuring the beam current of a charged particle beam of a charged particle beam device having a charged particle beam source, the method comprising:
modulating the charged particle beam current; and
inductively measuring the charged particle beam current for generating a measured signal.

11. The method of claim 10, wherein the charged particle beam current is modulated with a chopper and wherein the modulation frequency is equal to or larger than 100 Hz, in particular between 100 Hz and 7 MHz.

12. The method according to any of claims 10 to 11, wherein the modulating is conducted with a beam blanker which deflects the beam over an aperture, in particular a beam shaping aperture.

13. The method according to any of claims 10 to 12 wherein, further comprising:
calibrating the measured signal with an electrometer measurement.

14. The method according to any of claims 10 to 13, wherein the measuring of the measured signal is conducted at least every 10 min or at least every hour.

15. A method of controlling the beam current of a charged particle beam of a charged particle beam device , the method comprising:
a method of measuring the beam current of a charged particle beam according to any of claims 10 to 14; and
adjusting the charged particle beam current.
